(19) Europäisches Patentamt

European Patent Office

Office européen des brevets

(11) **EP 4 447 349 A1**

(12) **EUROPEAN PATENT APPLICATION**

(43) Date of publication:
**16.10.2024 Bulletin 2024/42**

(21) Application number: **23305579.7**

(22) Date of filing: **14.04.2023**

(51) International Patent Classification (IPC):
***H04L 1/00*** (2006.01)

(52) Cooperative Patent Classification (CPC):
**H04L 1/0041;** G06N 3/0455; G06N 3/0464;
G06N 5/022; H03M 7/3059

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Commissariat à l'énergie atomique
et aux énergies alternatives
75015 Paris (FR)**

(72) Inventors:
• **SANA, Mohamed
38054 GRENOBLE CEDEX 09 (FR)**
• **CALVANESE STRINATI, Emilio
38054 GRENOBLE CEDEX 09 (FR)**

(74) Representative: **Brevalex
Tour Trinity
1 B Place de la Défense
92400 Courbevoie (FR)**

(54) **CODEBOOK CONSTRUCTION METHOD, COMMUNICATION METHOD, COMPUTER
PROGRAM AND COMPUTER-READABLE STORAGE MEDIUM**

(57)    A method for constructing a codebook of transformations to equalize a semantic channel between a language generator ($\lambda$) and a language interpreter (I), the language generator ($\lambda$) encoding base observations (bm) into base symbols (x) while preserving base semantic meanings (bs);
the language interpreter (I) outputting target observations (tm) based on target symbols while preserving target semantic meanings (ts);
the codebook comprising transformation(s) (T) transforming base symbols (xi) endowed with base semantic meanings (bsi) into target symbols (yj) endowed with target semantic meanings (tsj);

the method comprises A10) identifying a transformation

(T) for which a function of transfer rates ( $\rho_{P_i \to Q_j}(T)$ ) for an association (aij) between a base semantic meaning (bsi) and an inferred target semantic meaning (tsi) reaches at least a predetermined threshold;

such transfer rate ( $\rho_{P_i \to Q_j}(T)$ ) representing a probability for base symbols (xi) endowed with a base semantic meaning (bsi) to be transformed by the transformation into inferred target symbols (yj) endowed with the inferred target semantic meaning (tsj).

FIG. 3

**Description**

TECHNICAL FIELD

The present disclosure relates to communication methods, an in particular semantic communication methods.

TECHNOLOGICAL BACKGROUND

Wireless communications are experiencing an unprecedented demand for communication bandwidth. In order to meet this demand, in parallel to the ongoing effort to explore traditional solutions, e.g. by increasing the frequencies, etc., semantic communication appears as an alternative solution to increase the bandwidth, and is now envisioned as a potential key enabler of future 6G networks.

Semantic communication is understood as a communication where the goal is essentially to convey a meaning: What matters is to ensure that the receiver understands the transmitted message, but without necessarily receiving a perfectly faithful and comprehensive transcription of the message initially transmitted.

In the context of semantic communication, a meaning (a semantic meaning) has to be transmitted by a transmitter to a receiver. This is possible thanks to a language (either natural or artificial), which endows messages (or observations of the world) with a semantic meaning.

More precisely, a first logic (or function, usually a functional unit of a data processing unit) is used by the transmitter to encode his observations (for instance, images): This logic is referred to as its "language generator"; then, a second logic (or function) is used by the receiver to recover the meaning of the information: This logic is referred to as the "language interpreter".

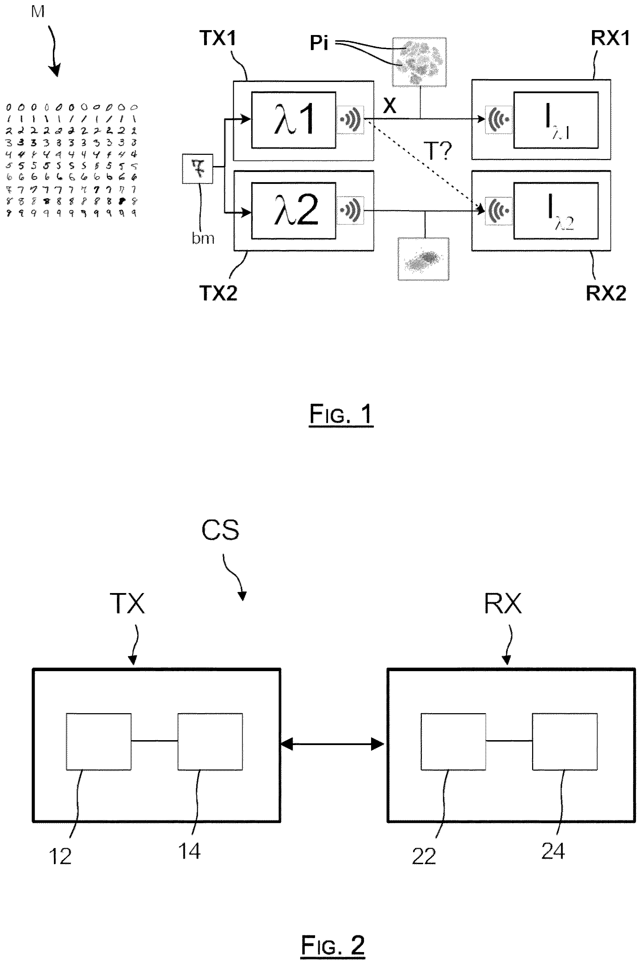

For instance, let us consider the exemplary communication illustrated by Fig.1.

As shown by Fig.1, a first transmitter TX1 and a second transmitter TX2 observe images of digits and encode underlying information for a first receiver RX1 and a second receiver RX2, respectively. Specifically, the first transmitter TX1 has to transmit to the first receiver RX1 a first semantic meaning which is the value of the digit shown on the image (i.e. '0', '1', ... '9'). Conversely, the second transmitter TX2 has to transmit to the second receiver RX2 a second semantic meaning which is only the parity of the digit shown on the image (i.e. even or odd).

Accordingly, two parallel communication channels are established: A first one between TX1 and RX1, and a second one between TX2 and RX2.

Each of these communication channels comprises a semantic channel and a syntactic channel, which in combination constitute the communication channel.

The semantic channel as known per se is a means of transmitting between intelligent agents (with reasoning and processing capabilities that follows a set of possible logics or languages) information that is understood by the receiver based on the meaning they assign to it. Thus, a semantic channel refers to the meaning or intention conveyed by a particular mode of communication (thus the selection of a logic or language, a strategy of communication - for instance pragmatic, having the transmitter selecting the semantic message in order to maximize the probability of correct interpretation at the receiver, or based on a cooperation plan where cost of semantic message extraction at the transmitter and semantic message interpretation at the receiver are shared under a given strategy, etc). For instance, in the context of language processing, a semantic channel is the way in which meaning is conveyed through words and phrases following a predefined logic. In the context of natural language processing (NLP) and computational linguistics, semantic channels are instrumental to represent the various ways in which intelligent agents can express their thoughts and ideas in a way that can be understood by others intelligent agents.

On the other hand, the syntactic channel refers to the medium through which the message is conveyed. That is, it is the channel through which the message is delivered, rather than the meaning or content of the message itself. The syntactic channel may generate distorsions, or noise, which can impair the transmission of meaning by the semantic channel.

In the two communication channels shown on Fig.1, the following communication patterns take place in parallel:

(1) Using his language generator $\lambda 1$ the first transmitter TX1 encodes a base observation bm as a first symbol x1, which is transmitted to the first receiver RX1. The first receiver RX1 receives symbol x1, interprets it using his language interpreter $I_{\lambda 1}$, and thereby generates a first receiver observation (or target observation) tm1 endowed with the digit shown on the initial image or observation bm.

(2) Similarly, using his language generator $\lambda 2$ the second transmitter TX2 encodes the base observation bm as a second symbol x2, which is transmitted to the second receiver RX2. The second receiver RX2 receives symbol x2, interprets it using his language interpreter $I_{\lambda 2}$, and thereby generates a second receiver observation tm2 endowed with the parity of the digit shown on the initial observation bm.

Herein, a language generator and a language interpreter (also called a semantic message generator and a semantic message interpreter) are defined as any pair of data processing units configured to cooperate as follows: The language generator takes in base observations (data) endowed with a semantic meaning and on this basis, outputs embeddings (symbols), which can then be decoded by the language interpreter into target observations, which are endowed with the same semantic meaning as the base observations.

Note that the language generator and the language interpreter usually are only configured to convey part of all the possible meanings (for instance: only some meanings, called the 'base meanings') that may be borne by the base observations.

The present disclosure concerns two possible issues that may arise in the situation described above.

The first issue may occur when a language generator and a language interpreter which should cooperate seamlessly to enable the receiver to obtain the meaning endowed in the initial observation actually do not perfectly match each other. The lack of matching may be caused, inter alia, by distorsions of the signal caused by transcriptions that may take place on the communication chain. Consequently, in such situation, the semantic communication may be found unsatisfactory.

The second issue may arise in situations, as in the above-described exemplary setting, in which a second receiver RX2 cannot receive or at least is not configured to correctly receive semantic meaning from symbols issued by a first transmitter TX1 with which it normally does not communicate. This is a sub-optimal situation since actually (as in the example of Fig.1), in many cases, it should be possible for the second receiver RX2 to retrieve semantic meaning from the symbols x issued by the first transmitter TX1. This happens in particular when the semantic meaning that the second receiver seeks to retrieve can be inferred from the meaning that the first transmitter TX1 tries to convey to his usual correspondent, the receiver RX1. Consequently, in such situations, the semantic communication may either be impossible, or in the best case may have poor performances.

References:

[1] M. Perrot, N. Courty, R. Flamary, and A. Habrard, "Mapping Estimation for Discrete Optimal Transport" in Advances in Neural Information Processing Systems, 2016, vol. 29.

[2] M. Sana and E. C. Strinati, "Learning Semantics: An Opportunity for Effective 6G Communications" in 2022 IEEE 19th Annual Consumer Communications & Networking Conference (CCNC), Jan. 2022, pp. 631-636.

[3] Sutton, Richard S., and Andrew G. Barto. "Reinforcement learning: An introduction". MIT press, 2018.

[4] Schulman, J., Wolski, F., Dhariwal, P., Radford, A., & Klimov, O. (2017). Proximal policy optimization algorithms. arXiv preprint arXiv:1707.06347.

SUMMARY

The object of the present invention is to remedy at least substantially the above-mentioned issues, and to propose methods and systems which make it possible to perform semantic communication in one situation or preferably in both the corresponding situations.

In order to meet that goal, it has been understood that the failure of semantic communication between a base transmitter TX and a target receiver RX takes place essentially because the symbol x output by the base transmitter TX using his language generator cannot be correctly or at least reliably decoded by the recipient (the target receiver RX): The language interpreter I of the target receiver RX fails to correctly decode symbol x as a target observation tm endowed with the semantic meaning endowed to the initial or base observation bm.

In order to overcome that mismatch, in accordance with the present disclosure it is proposed to semantically align a base symbol x outputted by a base transmitter, by applying thereto a transformation so as to obtain a transformed or target symbol y, suitable to be correctly decoded by the language interpreter of the target receiver RX. Applying this transformation makes it possible to provide to the target receiver RX a suitable target symbol y, with which it can generate a target observation tm correctly endowed with a target semantic meaning, called inferred semantic meaning, which is a meaning inferred by the base semantic meaning of the base observation bm. Applying such transformation in order to enable the semantic communication is called equalizing the semantic channel between the transmitter and the receiver.

Although a single transformation may be sufficient in some cases to transform base symbols into appropriate target symbols, in many cases, a plurality of transformations are necessary to correctly transform the base symbols into target symbols.

A set of one or more transformations is called a codebook.

Based on the foregoing considerations, a first object of the present disclosure is to propose a computer-implemented method for constructing a codebook of transformations to equalize a semantic channel between a language generator and a language interpreter, the transformation being suitable to adequately transform the symbols outputted by the language generator into target symbols suitable to be decoded using the language interpreter, even when the language generator and the language interpreter do not perfectly match each other.

In this method, the language generator is configured to encode a base observation endowed with a base semantic meaning into a base symbol endowed with the same base semantic meaning; and the language interpreter is configured, based on a target symbol endowed with a target semantic meaning, to output a target observation endowed with the same target semantic meaning.

The codebook comprises at least one transformation transforming base symbols endowed with base semantic meanings into target symbols endowed with target semantic meanings.

The method comprises the step of, an association being defined between a base semantic meaning and an inferred target semantic meaning:

A10) identifying, within a class of transformations, a transformation for which a function of at least one transfer rate

$\rho_{P_i \to Q_j}(T)$ of information for an association reaches at least a first predetermined threshold; a (regular) transfer rate

$\rho_{P_i \to Q_j}(T)$ for an association of a transformation representing, for the base symbols endowed with the base semantic meaning, a probability for these base symbols to be transformed by the transformation into target symbols, called inferred symbols, which are endowed with the inferred target semantic meaning associated with the base semantic meaning.

Once a transformation has been identified at step A10, a step A20 of including the transformation in the codebook is normally carried out.

It should be noted that for one base semantic meaning, there may be several target semantic meanings which can be inferred by the base semantic meaning.

The transfer rate $\rho_{P_i \to Q_j}(T)$ (or transfer rate of information) can be considered as representative of a probability for the base symbols endowed with the base semantic meaning to be translated into an inferred symbol endowed with the inferred semantic meaning which then has to be encoded into a target observation.

Advantageously, the above proposed method makes it possible to identify one or more transformations which is or are suitable to satisfactorily convey the base semantic meaning from the transmitter to the receiver, even when the language generator and the language interpreter do not perfectly match each other.

Various functions, and various thresholds, can be selected to perform step A10 in order to identify the proper transformations.

In some embodiments, the function of a least one transfer rate $\left(\rho_{P_i \to Q_j}(T)\right)$ is a weighted sum of transfer rates for different associations.

In this case, the various weights of the sum may be set depending on the importance alloted to correct transmission of meaning for the respective associations.

In some embodiments, a transformation is included in the codebook for each association between a base semantic meaning and a target semantic meaning that can be inferred (or implied) by the base semantic meaning.

Preferably at step A10, the transformation for which said function of transfer rates of information of said at least one association reaches at least said predetermined threshold is identified by identifying a transformation which maximizes, over the class of transformations, said function of a least one transfer rate of information of said at least one considered association. Indeed, when such maximum has been found, one can assume that the function reaches at least the predetermined threshold.

In this case, the transformation can be identified by solving the argmax-based equation:

$$T_{i,j} = \underset{T \in \mathcal{T}}{\arg\max} \, \rho_{P_i \to Q_j}(T) \quad (1)$$

Accordingly in this case, the transformation can be seen as the transformation for which a probability for the base symbols endowed with the base semantic meaning (bsi) to be translated into a target symbol endowed with a target semantic meaning inferred from the base semantic meaning is maximum.

Any class of transformations suitable for outputting a predicted target symbol based on a base symbol can be used to implement the method.

For instance, the class of transformations may be a set of neural networks, of kernel mappings, or of affine transformations. The affine transformations may include for instance translations, shifts, scaling, rotations, ..).

Various methods can be used to identify the transformation which, for the considered association between the base semantic meaning and the considered inferred semantic meaning, maximizes the transfer of information.

For instance, in some embodiments, the transformation is identified at step A10 as a transformation for which said function, when applied to tightened transfer rates $\left(\rho_{P_i \to Q_j}(T)\right)$ for said at least one association, reaches at least a second predetermined threshold, a tightened transfer rate $\rho_{P_i \to Q_j}(T)$ for a transformation representing a probability for the base symbols endowed with the base semantic meaning to be transformed by the transformation into target symbols belonging to a strict subset of the set of the inferred symbols, for instance the set of target symbols located at a distance smaller than a threshold radius from a barycenter of a set of the inferred symbols.

The second predetermined threshold is normally defined based on the first predetermined threshold. It may for instance be equal to the first predetermined threshold.

In these latter embodiments, the algorithm used to identify transformations based on tightened transfer rates may be simpler than some algorithms based on regular transfer rates; the second predetermined threshold may be set so that for the transformations identified in this manner, the function of said at least one transfer rate $\rho_{P_i \to Q_j}(T)$ for an association reaches at least the first predetermined threshold.

In these latter embodiments, the radius threshold is preferably determined so that all target symbols located at a distance smaller than a threshold radius from a center of the set of inferred symbols are inferred symbols.

The number of transformations included in the codebook generally depends on the number, the variety of associations which have to be taken into account to convey semantic meaning.

Importantly, it has been noticed that in most cases some transformations are quite efficient for conveying meaning not only for one, but for two or more associations. Consequently, that transformation can be used to convey meaning for all these associations. This makes it possible to reduce the number of transformations in the codebook, that, is, to prune the codebook, thus advantageously reducing complexity, hence computing times.

Accordingly, in some embodiments, the codebook construction method comprises pruning the codebook by removing one or more transformations from the codebook, when removing said one or more transformations does not reduce an accuracy of the codebook, the accuracy of the codebook being calculated by summating, over all associations between a base semantic meaning and an inferred semantic meaning (isj), a maximum value of the transfer rate of information for the association.

In addition, in some embodiments, the codebook construction method comprises, after having constructed an initial codebook, constructing an updated codebook comprising only a subset of transformations of the initial codebook having lowest entropy values.

These entropy values h(T), which represent the entropy of an individual transformation T, can be defined by equation (2) or (2') below:

$$h(T) = -\sum_{\sigma ij} \rho_{P_i \to Q_j}(T) \log\left(\rho_{P_i \to Q_j}(T)\right) \quad (2)$$

$$h(T) = -\sum_{\sigma ij} \rho_{P_i \to Q_j}(T) \log\left(\rho_{P_i \to Q_j}(T)\right) + \left(1 - \rho_{P_i \to Q_j}(T)\right) \log\left(1 - \rho_{P_i \to Q_j}(T)\right) \quad (2')$$

where the sum is calculated over all the associations oij between a base semantic meaning bsi and an inferred semantic meaning isj.

In some variants of these embodiments, transformations from the initial version of the codebook are added to the updated version of the codebook only if the entropy of the whole codebook does not exceed a predetermined threshold.

In addition, in these embodiments the following restriction may be considered.

A transformation may be added to the updated version of the codebook preferably only if doing so does not increase the entropy of the updated version of the codebook over the above-mentioned predetermined threshold but (strictly) increases the accuracy of the updated codebook.

Furthermore, in some embodiments, the codebook construction method comprises pruning the codebook by selecting transformations to be kept in or to be removed from the codebook based on an acceptance criterion, the acceptance criterion for a transformation being based on the transfer rate of the transformation for at least one association between a base semantic meaning and an inferred semantic meaning. In particular, transformations can be kept in or removed from the codebook based on their relative values of the acceptance criterion for the same at least one considered associations.

The codebooks constructed according to the above methods can then be used to perform semantic communication.

Accordingly, a further aspect of the present disclosure concerns a computer-implemented communication method for transmitting semantic information from a transmission module to a reception module;

the method comprising the steps of:

> S10) encoding a base observation as a base symbol using a language generator of the transmission module;
> S20) translating the base symbol into a target symbol using a transformation of a codebook constructed with one of the codebook construction methods defined above;
> S30) decoding the target symbol to obtain a target observation using the language interpreter of the reception module.

In some embodiments, the transformation used at step S20 is selected based on the base observation, the base symbol, a predetermined probability distribution of the base observations, and/or a predetermined probability distribution of transformations that have been used in past steps S20.

In some embodiments, the transformation used at step S20 for translating the base symbol is selected as a or as the transformation (T) maximizing a transfer rate from the base symbol to a corresponding inferred target symbol.

In some embodiments, the transformation used at step S20 is selected as a transformation for which an acceptance criterion is maximum, the acceptance criterion being based on the transfer rate or rates $\rho_{P_i \to Q_j}(T)$ of information of at least one association.

In some embodiments, the transformation used at step S20 is selected based on a stochastic policy, said policy being determined by minimizing the expectation of a risk of misinterpretation when following a policy, given a base observation, based on a probability distribution of the base observations, the risk of misinterpretation when following a policy given a base observation being minimized by maximizing a weighted sum over all the associations of a transfer rate between the base semantic meaning and the inferred semantic meaning of the association weighted by a probability of the base symbol given the base observation.

The communication method may advantageously be implemented to perform communication between a transmission module and a reception module which are not located at the same place. Consequently, during step S20 on one hand, the information has to be transmitted for the location of the transmission module to the location of the reception module; during this step, the transformation has to be applied to the base symbol.

The following solutions can be chosen to combine these two aspects.

In some embodiments of the communication method, at step S20, the base symbol is translated into the target symbol, and then the target symbol is transmitted to a distant location; the base symbol is transmitted to a distant location, and then the base symbol is translated into the target symbol; or the base symbol undergoes a first transformation which yields a first output, the first output is transmitted to a distant location, and then undergoes a second transformation, wherein the combination of the first and second transformations is the transformation of the codebook applied at step S20.

Consequently, in the last case, the output of the second transformation is the target symbol, that is, the target symbol that would be outputted by the transformation upon receiving the base symbol as an input.

In the above sentence, the expression 'distant location' may be any non null distance. It essentially means that the transmission module and the reception module are two physically distinct entities. They can be separated by a distance of 10 centimeters, or 1 kilometer or more. The transmission performed at step S20 is usually performed using a communication system, for instance a wireless communication system. This transmission may include encoding and decoding the transmitted information.

In particular implementations, the various steps of the codebook construction method and/or of the communication method are determined by computer program instructions.

Consequently, the invention also provides a computer program including instructions for executing the steps of a codebook construction method as defined above, when said program is executed by one or more computers, and a computer program including instructions for executing the steps of a communication method as defined above, when said program is executed by one or more computers.

The program may use any programming language, and be in the form of source code, object code, or code intermediate between source code and object code, such as in a partially compiled form, or in any other desirable form.

The invention also provides a non-transitory computer-readable storage medium having recorded thereon the computer program as mentioned above.

The data medium may be an entity or device capable of storing the program. For example, the medium may comprise storage means, such as a read only memory (ROM), e.g. a compact disk (CD) ROM, or a microelectronic circuit ROM, or indeed magnetic recording means, e.g. a floppy disk or a hard disk.

Alternatively, the data medium may be an integrated circuit in which the program is incorporated, the circuit being adapted to execute or to be used in the execution of the method in question.

Accordingly, the present disclosure further concerns a communication system comprising at least one processor and at least one non-transitory computer-readable storage medium, the communication system being configured to implement a communication method as defined above.

BRIEF DESCRIPTION OF THE DRAWINGS

The invention and advantages thereof will be better understood upon reading the detailed description which follows, of embodiments given as non-limiting examples. This description refers to the appended drawings, wherein:

- Fig. 1 already partially described is a schematic drawing showing semantic communication taking place between a first transmitter and a first receiver, and a second transmitter and a second receiver;
- Fig.2 is a schematic drawing showing the physical components of a semantic communication system according to the present disclosure;
- Fig.3 is a schematic drawing showing the functional units of the semantic communication system shown on Fig.2;
- Fig.4. is a schematic drawing representing a transfer rate of information between a base atom and a target atom involved in a communication method according to the present disclosure;

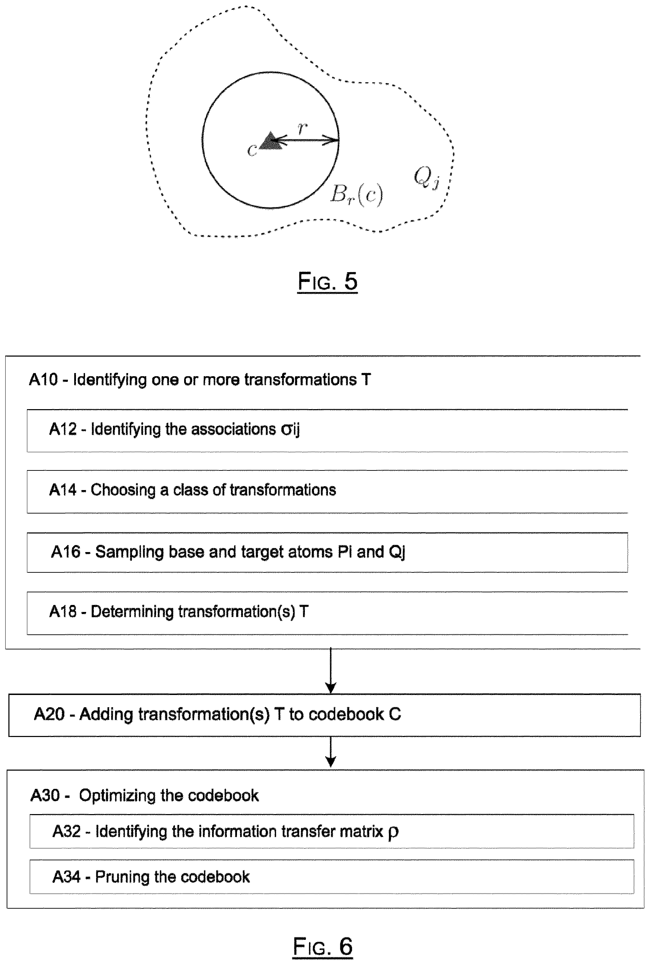

- Fig.5. is a schematic drawing illustrating a specific algorithm to determine a transformation, in a method according to the present disclosure;
- Fig.6 is a bloc diagram showing the steps of a method for constructing a codebook according to the present disclosure;
- Fig.7 is a bloc diagram showing the steps of a semantic communication method according to the present disclosure; and
- Fig.8 is a schematic drawing showing comparative results obtained to compare codebook construction methods according to the present disclosure to state of the art methods.

DETAILED DESCRIPTION OF EMBODIMENTS

Figure 2 is a block diagram illustrating an exemplary communication system CS for implementing methods according to the present disclosure.

Communication system CS includes a transmission module TX and a reception module RX.

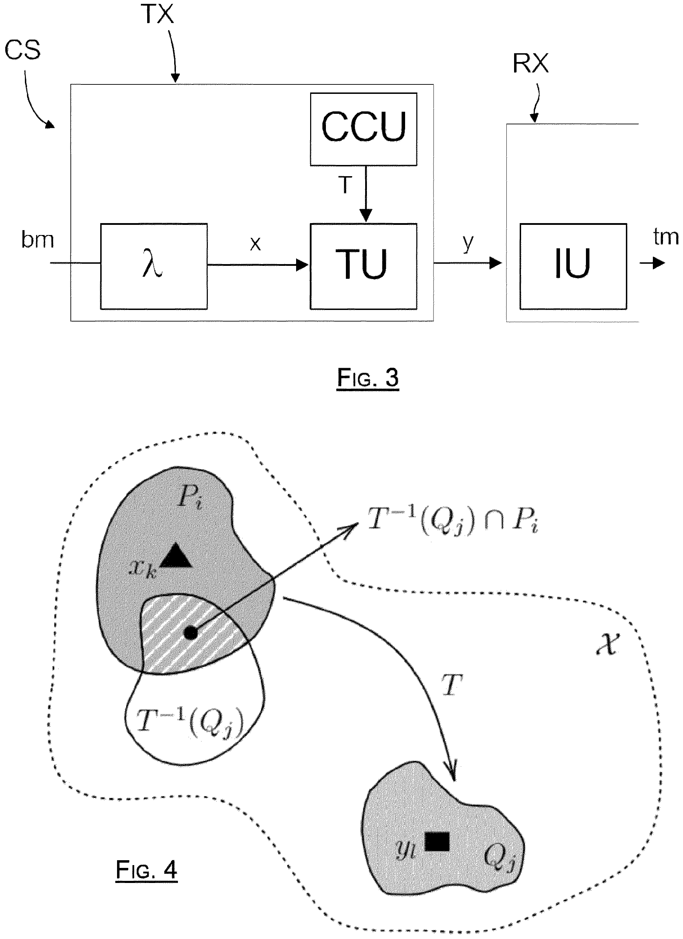

The main functional units of the transmission module TX and of the reception module RX are shown on Fig.3.

Specifically, in the embodiment described herein, the transmission module TX comprises a language generation unit, or language generator $\lambda$, a codebook construction unit CCU and a transformation unit TU. On the other hand, the reception module RX comprises a language interpretation unit IU.

Each one of these four functional units ($\lambda$, CCU, TU and IU) is functionally an independent unit (though cooperating with the other units). Consequently, each of them may be implemented in a separate physical module, for instance a computer, and may be located at any location, distant or not from the other functional units.

The codebook construction unit CCU is configured to execute the steps of the codebook construction method according to the present disclosure. It is therefore configured to generate a codebook C containing transformations T suitable to align base symbols x into target symbols y.

The language generation unit $\lambda$ is configured to encode base observations bm into base symbols x (step S10 of the communication method according to the present disclosure).

The transformation unit TU is configured to translate the base symbols x into target symbols y using one of the transformations T of the codebook C (step S20 of the communication method).

The language interpretation unit IU is configured to decode the target symbol y to obtain target observations tm using the language interpreter I.

The transmission module TX and the reception module RX are communication modules which both have the same physical architecture shown on Fig.2.

Each of these modules comprises one or more Computer Processing Units (CPUs) and/or Graphic Processing Units (GPUs) 12 or 22 for executing modules or programs and/or instructions stored in memory 14 or 24 and thereby performing processing operations, memory 14 or 24, and one or more communication buses for interconnecting these components. The memory 14, 24 includes high-speed random access memory, such as DRAM, SRAM, DDR RAM or other random access solid state memory devices, and may include non-volatile memory, such as one or more magnetic disk storage devices, optical disk storage devices, flash memory devices, or other non-volatile solid state storage devices. The memory 14,24 optionally includes one or more storage devices remotely located from the CPU(s) 12,22. The memory 14, 24, or alternately the non-volatile memory device(s) within the memory 14,24, comprises a non-transitory computer readable storage medium. In some embodiments, the memory 14,24, or the computer readable storage medium of the memory 14,24 stores programs, data structures, etc, in order to implement one or more of the following functional units: the codebook construction unit CCU, the language generation unit λ, the transformation unit TU, the language interpretation unit IU.

The transmission module TX and the reception module RX are typically placed in two different locations, namely a transmission location TL and a reception location RL. The communication system CS therefore makes it possible to perform semantic communication from the transmission location TL to the reception location RL. In some implementations however, the transmission module and the reception module conversely are the same machine.

The codebook construction method performed by the codebook construction unit CCU will now be described.

It is considered here that a base semantic meaning bsi, present in a base observation bm, has to be transmitted to a recipient by semantic communication via the language generator λ, the transformation unit TU and the target interpreter I.

It is further supposed that, for the considered base semantic meaning bsi, there corresponds at least one semantic meaning, called inferred semantic meaning isj, which can be inferred from the base semantic meaning bsi, and that consequently has to be transmitted to the recipient of the communication. In this situation, the couple comprising the base semantic meaning bsi and the inferred semantic meaning isj is called 'an association'.

The first step A10 of the method is to identify one or more transformations T suitable to translate base symbols x bearing the base semantic meaning bsi into inferred symbols y bearing the corresponding inferred semantic meaning tsj.

In order to make it easier to understand how such transformations T can be identified, the explanations below will be given in relation with the example of Fig.1.

In this example, the base semantic meaning bsi can be "the observed digit is digit i"; and the inferred meaning tsj can be "the digit is even".

Accordingly, the purpose of the transformation T is to transform a base symbol x outputted by the language generator λ based on the base observation bm showing a digit i into a target symbol y based on which the language interpreter I can then generate a target observation endowed with a target meaning tsj showing or bearing the parity of the digit i.

In the exemplary case illustrated by Fig.1, the base observations bm whose semantic meaning is to be transmitted are the small images or thumbnails as shown on Fig.1. Each of these thumbnails represents a digit i (i=0....9).

The semantic meaning that has to be transmitted is the parity of the digit but the specific situation considered here is that the language generator used is the language generator λ1, which is normally used to transmit the digit itself, as semantic meaning, but not the parity of the digit, and that the language interpreter that has to be used is the language interpreter I2, which normally is used to generate target observations tm endowed with a meaning which is the parity of the digit.

Consequently, the language generator λ1 and the language interpreter I2 do not perfectly match each other; consequently, a semantic channel equalization has to take place to ensure that the correct semantic message (the parity of digit i) is conveyed to the recipient of the target message tm.

In the following, unless mentioned otherwise, for sake of simplicity, since the first language language generator λ1 and the second language interpreter I2 are mainly referred to, they will be noted respectively λ and I.

As one can see on Fig.1, each digit i may appear in observations bm under multiple shapes.

Accordingly, each base observation bm may be encoded by the language generator λ by many symbols x. It is assumed here that in the set of base symbols x, noted X, the symbols x associated to the same digit i are clustered. For this reason, the set X of base symbols may schematically appear as shown on Fig.4., with 10 clusters Pi, i=0 to 9, each cluster or 'atom' Pi being associated to a digit i.

(Similarly, a base observation bm is encoded by the second language generator λ2 by many symbols x. The set X2 of base symbols for the second language generator λ2 may schematically appear as shown on Fig.4., with 2 clusters Qj, j=0 or 1, corresponding to the two possibilities, even or odd, for the parity of each digit.)

The language generator λ accordingly is modelled as a mapping function from the set M of base observations bm to the set of base symbols X.

Similarly, the language interpreter I is modelled as a mapping function from the set of target symbols Y to the set of target observation M. The set of base symbols X and the set of target symbols Y in some embodiments are the same set.

Accordingly, during semantic communication the following operations are successively carried out to obtain a target observation tm based on a base observation bm:

$$x = \lambda(bm); \; y=T(x); \; tm = I(y) \quad (3)$$

The language generator $\lambda$ and the interpreter I can be either deterministic or stochastic.

A language generator $\lambda$ generally associates a plurality of symbols x to one specific value of semantic meaning that may be endowed to a base observation m. Similarly, a language interpreter I based on a plurality of target symbols Y may generate target observations all endowed with the same one specific value of semantic meaning.

The set of symbols associated by the language generator $\lambda$ or by the language interpreter I to one semantic meaning is called 'an atom'.

Each language generator $\lambda$ accordingly defines a partition of the set of base symbols X into base atoms P, and each language interpreter I defines a partition of the set of target symbols Y into target atoms Q. Consequently, each association between a base semantic meaning bsi and an inferred semantic meaning isj can also be considered as being an association between the base atom Pi (defined by the base semantic meaning bsi) and the target atom Qj (defined by the inferred semantic meaning isj).

For a considered transformation T and for a considered association between a base atom Pi and a target atom Qj, the transfer rate $\rho_{P_i \rightarrow Q_j}(T)$ of information represents a probability for the base symbols of atom Pi to be transformed by the transformation into inferred target symbols yj which are endowed with the inferred target semantic meaning tsj.

In a deterministic setting, the transfer rate $\rho_{P_i \rightarrow Q_j}(T)$ of information accordingly represents a proportion of the base symbols x endowed with a considered base semantic meaning bsi which are transformed by the transformation T into inferred symbols y which are endowed with the inferred semantic meaning isj.

In a probabilistic setting, the density of probability of the distribution of base atoms P is noted $\mu$.

In this case, the transfer rate $\rho_{P_i \rightarrow Q_j}(T)$ of information can be calculated as follows:

$$\rho_{P_i \rightarrow Q_j}(T) = \frac{\mu(T^{-1}(Q_j) \cap P_i)}{\mu(P_i)} \quad (4)$$

where $T^{-1}(Qj)$ is the pre-image of the target image Qj under one iteration of the transformation T.

The transfer rate $\rho_{P_i \rightarrow Q_j}$ quantifies the fraction of the volume of a considered base atom Pi that ends up in the target atom Qj under the transformation T.

According to the present disclosure indeed, in order to make the transmission of meaning possible through the transmission module TX and the reception module RX, at least for the association between the base atom Pi and the corresponding or inferred atom Qj, the transformation T preferably has to transport most of the symbols x belonging to atom Pi into the corresponding inferred atom Qj (in other words, it is preferable that as many images of a symbol x of base atom Pi be symbols y of inferred target atom Qj).

The function T can preferably be identified by solving the equation:

$$T_{ij} = \underset{T \in \mathcal{T}}{\operatorname{argmax}} \; \rho_{P_i \rightarrow Q_j}(T) \quad (1)$$

More broadly, at step A10 transformations T can be identified by performing the following steps.

A12) Associations identification

At step A12, the associations oij between a base semantic meaning bsi and a target semantic meaning tsj which can be inferred by the base meanings bsi are identified.

A14) Choice of the class of transformations

At step A14, a class of transformations for the transformations T is selected. This class can be chosen among the classes of neural networks, kernel mappings, affine transformations (translations, shifts, scaling, rotations, ..), etc.

A16) Sampling the base and inferred atoms

In the embodiment described here, the language generator and the language interpreter I process stochastic variables.

At step A16, for each association oij between a base semantic meaning bsi and an associated inferred semantic meaning bsj, a finite sample Xi of Nx symbols of the base atom Pi and a finite sample Yj of Ny symbols of the inferred atom Qj are drawn.

These samples can be drawn based on distributions of the symbols respectively in the base atom Pi and the inferred atom Qj.

These distributions of probabilities for a base atom and respectively an inferred atom may be defined as:

$$\mu_i = \sum_{k=1}^{N_X} p_{i,k} \delta_{xik} \quad \text{and} \quad \nu_j = \sum_{k=1}^{N_Y} q_{j,k} \delta_{yjk} \quad (5)$$

where $\delta_x$ denotes a unit point mass at the symbol x of X, $p_{i,k}$ and $q_{j,k}$ are the probability masses associated to the $k$-th sample in Xi and Yj, respectively and belong to the probability simplex, i.e. $\Sigma_k p_{i,k} = 1$ and $\Sigma_k q_{j,k} = 1$

Accordingly, for each association oij, the samples Xi = $\{x_{i,k} \in P_i, k = 1, ..., N_X\}$ - $\mu_i$ and Yj = $\{y_{j,k} \in Q_j, k = 1, ..., N_Y\}$ ~ $\nu_j$ are drawn.

A18) Optimized transformation determination

The transformation T is then identified by optimizing a performance in transferring semantic meaning from one or more base atoms to one or more target atoms.

The maximization may be performed under some constraints.

The maximization usually aims at maximizing a criterion.

In some implementations, this criterion focuses on a single association, considered most important, and aims at maximizing the transfer rate from the base atom Pi of that association toward the inferred target atom Qj of that association.

In other implementations, this criterion takes into account several associations. In this case, the criterion aims at maximizing a weighted sum (or an equivalent function) of the transfer rates from a base atom Pi of one of the considered associations toward the target atom Qj inferred by this base atom Pi.

For instance, each transformation may be associated to a cost either related to complexity, energy thereof the maximization may guarantee a certain cost.

In some implementations, the transformation should be constrained not to transfer the symbols from the base atoms to somewhere else other than a specified (set of) target atoms.

The identification of the transformation T in the case where only one association is taken into account will now be described below.

In this case, a specific transformation Tij can be identified for each association oij between a base atom Pi and an inferred target atom Qj as follows.

For each association oij, transformation Tij is determined by solving the equation (1):

$$Tij = \underset{T \in \mathcal{T}}{\arg\max} \, \rho_{P_i \to Q_j}(T)$$

Any suitable method for solving this equation, even approximately, can be used. The problem to solve may be seen as an optimal transport problem, consisting in finding the optimal transformation to transport the base symbols from the base atom to the inferred atom.

For instance, instead of solving equation (1) above (which is based on regular transfer rates), the transformation T may be identified by solving the equation below:

$$Tij = \underset{T \in \mathcal{T}, \gamma \in \Gamma}{\operatorname{argmin}} \left( \left\| T(\boldsymbol{Xi}) - N_X \boldsymbol{\gamma} \mathbf{B}_r(\boldsymbol{Yj}) \right\|_F^2 + \alpha \left\langle \boldsymbol{\gamma}, \boldsymbol{D}_{i,j} \right\rangle_F + \beta h(T) \right) (6)$$

The details on how to implement such optimization can be found in Ref.[1].

In this case, the transformation T is not identified based on regular transfer rates, but based on tightened transfer rates.

Indeed in this case, the transformation T is identified by minimizing a function (shown in Equation (6)) so as to maximize a probability for a base symbol xi endowed with the base semantic meaning bsi to be transformed by the transformation into a target symbol yj belonging to a strict subset of the set of the inferred symbols Qj: Specifically, according to equation 6, this strict subset is the ball of radius r centered at the barycenter of the target atom Qj.

The problem of finding the optimized translation as an image of the argmax function for function $\rho_{P_i \rightarrow Q_j}(T)$ is therefore replaced by the Monge-Kantorovitch problem defined by equation 6.

In this equation, $\mathbf{B}_r(\mathbf{Y}_j)$ is a barycentric mapping of the sample in $\mathbf{Y}_j$ into a ball of radius $r$ centered in $c$ (e.g., atom centroid): $\{x \in \mathcal{X} \mid d(c, x) \leq r\}$ (see Fig.4) ; $\alpha$ and $\beta$ are hyper-parameters ; h(T) is a regularization term ; $\|\cdot\|_F$ and $\langle \cdot, \cdot \rangle_F$ are the Frobenius norm and the dot product.

Solving the equation below amounts to seek a transport map that transports samples $\mathbf{X}_i$ from atom Pi into a ball $\mathbf{B}_r(\mathbf{Y}_j)$ of the target sample $\mathbf{Y}_j$. This is because, depending on the goal of the semantic communication, what matters is that transported samples $\mathbf{X}_i$ fall in $Q_j$ (i.e., that $\rho_{P_i \rightarrow Q_j}(T) = 1$ ).

The radius r of this ball controls the confidence at the reception module RX in correctly interpreting as inferred semantic meaning isj the base semantic meaning bsi sent by the transmission module TX. By forcing the inferred symbols to belong to a core portion of the inferred atom, this method increases the robustness of the transmission of the semantic meaning against noise introduced by the syntactic or physical channel. In the following, the codebook created at step S20 is noted

$$\mathcal{C}_{\mathcal{T}}^{(r)},$$

parameterizedby r and depending on the class of transformations, also noted T.

The equation (2) can for instance be solved efficiently using a block coordinate descent approach as proposed in document Ref.3.

When the communication conditions evolve over time, the codebook construction method can be executed iteratively, for instance periodically, to adjust the codebook to the current conditions of communication.

In this purpose, when the codebook construction method is executed, the radius of the ball one can set (in particular, dynamically) based on an estimation of the signal-to-noise ratio on the syntactic/physical channel. Doing so increases the robustness of the codebook with respect to possible semantic distortion possibly introduced by the physical channel.

A20 - Addition of transformation to the Codebook

Then, for each association oij, the corresponding identified transformation Tij is included in the codebook C.

A30 - Codebook optimization

Then at step S30, the codebook undergoes an optional optimization operation in order to reduce the size of the codebook, if possible.

It has appeared indeed that having one (or more) transformation for each association is often quite unnecessary, since a given transformation may often suffice to efficiently convey semantic meaning not only for one association, but for several ones.

For this reason, in many cases it may be useful to reduce the number of transformations contained in the codebook. This can be done as follows.

A32 - Information transfer matrix determination

As a first step A32, an information transfer matrix ρ is calculated.

This information transfer matrix ρ belongs to $[0,1]^{N_P \times N_Q \times N_C}$, where Nc is the number of transformations in the codebook C, $N_P$ is the number of base atoms and $N_Q$ is the number of target atoms. In matrix ρ, each component ρ(i,j,k) of the matrix for a transformation Tk (k=1... Nc) is defined as:

$$\boldsymbol{\rho}[i,j,k] = \rho_{P_i \to Q_j}(T_k) \quad (7)$$

When the set of associations σ constitutes a one-to-one or many-to-one mapping, the information transfer matrix ρ can be reduced to a 2D squared matrix ρ belonging to $[0,1]^{Nc \times NQ}$:

$$\boldsymbol{\rho} = \begin{pmatrix} \rho_{P_1 \to Q_{\sigma(1)}}(T_1) & \cdots & \rho_{P_{N_P} \to Q_{\sigma(N_P)}}(T_1) \\ \vdots & \ddots & \vdots \\ \rho_{P_1 \to Q_{\sigma(1)}}(T_{N_P}) & \cdots & \rho_{P_{N_P} \to Q_{\sigma(N_P)}}(T_{N_P}) \end{pmatrix} \quad (8)$$

In the information transfer matrix ρ, a value ρ[i,j] equal to 1 means that the considered transformation Tij of the codebook is able to perfectly align base atom Pi with inferred atom Qj. In other word, for each symbol x of the base atom Pi, the inferred symbol y obtained by applying Tij to base symbol x belongs to the inferred atom Qj. Consequently, it will be possible for reception module RX to recover exactly the inferred semantic meaning isj if Tij is used to transmit the base semantic meaning bsi.

In practice, the information transfer matrix ρ can be drawn for instance using a Monte-Carlo sampling method, for each considered association oij, by applying each transformation to the samples Xi and Yj from the base atom Pi and the target atom Qj respectively.

A34 - Codebook pruning

Different methods may be used to reduce the size of the codebook.

A first method consists in allowing a transformation to be removed from the codebook when removing that transformation does not reduce the accuracy A(C) of the codebook C.

The accuracy A(C) of the codebook is here a variable representative of a capacity of the transformations of the codebook to transfer the base semantic meaning endowed to the base symbols x of the base semantic set X to the target symbols of the target semantic set Y, assuming that for each association, the transformation which is the most efficient to transmit semantic meaning from the base semantic set to the target semantic set will be employed for the communication.

This accuracy can for instance be calculated as follows, by summating, over all associations oij between a base semantic meaning bsi and an inferred semantic meaning isj, a maximum value of the transfer rate ρij of information for the association:

$$A(C) = \sum_{\sigma ij} \max_{T \in \mathcal{C}_T} \rho_{P_i \to Q_j}(T) \quad (9)$$

A second method consists in pruning the codebook C so as to reduce its entropy. The entropy H(C) of a whole codebook C is defined as the sum of the entropy values H(T) of the different transformations of the codebook:

$$H(C) = \frac{1}{N_C} \sum_{T \in \mathcal{C}_T} h(T) \quad (10)$$

The codebook in this case may be generated by progressively adding transformations in an updated version C' of the codebook.

Starting from an empty set, the updated codebook C' is constituted by first adding the transformation T having the lowest entropy, and then iteratively adding transformations of increasing individual entropy h(T), the transformations being picked from the original codebook C.

At each iteration, a new transformation T may be added to codebook C' only if:

- the total entropy of the updated codebook remains under a predetermined entropy threshold H0; and
- adding the transformation to codebook C' causes its accuracy A(C') to increase; conversely, if a transformation does not increase the accuracy of codebook C', it is removed from consideration.

The codebook construction method has been presented before the communication method because in most cases, the codebook is constructed indeed before the communication takes place.

However, in some embodiments, the codebook is constructed on request, that is, when the meaning of an observation m has to be transmitted and the communication method consequently is implemented. This is particularly the case when the codebook comprises only one transformation. Constructing the codebook is equivalent in this case to identifying the transformation of the codebook, that is, essentially performing step A10 of the codebook construction method.

Therefore, the codebook construction method may in some cases be performed during the communication method itself.

Exemplary embodiments of communication methods according to the present discussion will now be described.

The method comprises the steps of:

S10) encoding a base observation bm as a base symbol x using the language generator $\lambda$;
S20) translating the base symbol x into a target symbol y using a transformation T of the codebook C;
S30) decoding the target symbol y to obtain a target observation tm using the language interpreter I.

Step S20 of translating the base symbol x into a target symbol y may comprise two sub-steps:

S22) selecting in the codebook the translation T that will be applied;
S24) applying the selected transformation.

In this method, the language generator does not need to perfectly match the interpreter I, since the transformation T will transform the base symbol x outputted by the language generator into a target symbol y endowed with a target semantic meaning is inferred from the base semantic meaning bs, so that the correct semantic meaning be correctly conveyed to the recipient of the transmitted observation tm.

In order to correctly perform the translation step S20, an appropriate strategy must be identified to properly select an appropriate transformation T from codebook C to be used during step S20.

This strategy is of course chosen in relation with the codebook that has been prepared.

Two types of strategies can be used: Naive strategies, in which the transformation is selected at step S20 without knowing the observation m; or semantic-aware strategies, in which conversely the transformation T is chosen given the drawn observation m.

A first possible naive strategy consists, in some embodiments, in choosing any transformation T at random from the codebook, without having any regard to the observation m that has been drawn. This strategy may be chosen if the transfer rate $\rho_{P_i \to Q_j}(T)$ is considered sufficient for all the associations oij between a base atom Pi and a target atom Qj.

In other naive strategies conversely, the transformation takes into account how the observations may be drawn as follows: The transformation is selected based on a predetermined probability distribution of the base observations, and/or a predetermined probability distribution of transformations that have been used in past steps S20.

In the first case, the transformation T is chosen based on a probability distribution of the base observations. It is supposed that this distribution has been determined beforehand. The transformation may be for instance by drawing an observation based on the probability distribution of the base observations, and then selecting the (or a) transformation of the codebook that has the highest transfer rate of information for the drawn observation.

In the second case, the transformation T is chosen simply by drawing a transformation from the transformations of the codebook, based on the probability distribution for these transformations to be drawn. This latter distribution in this case is based on (or representative of the distribution of) transformations that have been used when the communication method has been used in the past, at successive steps S20 of the method.

In some embodiments, the transformation T to be used at step S20 is selected as a drawing of a stochastic policy $\pi$.

The policy π is then a codebook selection strategy such that π(T,m) specifies the probability for selecting a transformation T of the codebook C given the observation m.

The risk associated with policy π, given an observation m (that is, when the semantic meaning of the observation m has to be transmitted), can then be defined as:

$$R(\pi, m) = 1 - \mathbb{E}_{T \sim \pi(T,m)} \left[ \sum_{\sigma ij} \mu(P_i|m) \cdot \rho_{P_i \to Q_j}(T) \right] \quad (11)$$

where $\mu(P_i|m)$ is the probability that the semantic symbol $x = \lambda(m)$ associated to observation m belongs to a considered base atom Pi.

Averaging this risk over all the possible observations m yields the global risk for policy π:

$$R(\pi) = \mathbb{E}_{m \sim p_{\mathcal{M}_k}(m)}[R(\pi, m)] = 1 - \mathbb{E}_{\substack{m \sim p_{\mathcal{M}_k}(m) \\ T \sim \pi(T,m)}} \left[ \sum_{\sigma ij} \mu(P_i|m) \cdot \rho_{P_i \to Q_j}(T) \right] \quad (12)$$

where $p_{\mathcal{M}_k}(m)$ is the probability for the observation m to be emitted (drawn).

The purpose is therefore to select the strategy P(π). This can be done by seeking to identify a Bayes-optimal strategy $\pi_{Bayes}$ which minimizes the average risk R(n) where n is the set Π of all possible policies :

$$\pi_{Bayes} = \arg \min_{\pi \in \Pi} R(\pi) \quad such \ that \ \sum_{T \in C} \pi(T, m) = 1, \forall m \in M \quad (13)$$

Different methods can be used to calculate the $\pi_{Bayes}$ policy.

It is possible in particular to follow a Bayes-optimal approach.

In a first approach, call a 'naïve' approach, the risk can be rewritten as:

$$R_{Naive}(\pi) = 1 - \mathbb{E}_{\substack{m \sim p_{\mathcal{M}_k}(m) \\ T \sim q}} \left[ \sum_{\sigma ij} \mu(P_i|m) \cdot \rho_{P_i \to Q_j}(T) \right]$$

$$= 1 - \mathbb{E}_{T \sim q} \left[ \sum_{\sigma ij} \mathbb{E}_{m \sim p_{\mathcal{M}_k}(m)}[\mu(P_i|m)] \cdot \rho_{P_i \to Q_j}(T) \right]$$

$$= 1 - \mathbb{E}_{T \sim q} \left[ \sum_{\sigma ij} \mu(P_i) \cdot \rho_{P_i \to Q_j}(T) \right] \quad (14)$$

In that case, the optimal policy can be calculated by solving equation (14) for the value of the risk $R_{Naive}$ expressed above.

This optimal policy can be solved in linear time using linear programming.

In this first approach, the base observation bm is not taken into consideration; indeed, the method consists in identifying a probability distribution of the transformations of the codebook regardless of the observations bm. Consequently, the identified policy π is merely a 'static' probability distribution on the codebook, which can be written as:

$$\pi(T,m) = \pi(T).$$

Conversely, a second approach for selecting a transformation T at step S20, consists in selecting transformation T based on the drawn observation m, or on the symbol x which has been output based on observation m by the language generator λ.

In this case for instance, the transformation may be selected as a (or the) transformation identified as maximizing a transfer rate ρij of information from a symbol x to an inferred target symbol y.

More broadly, the transformation used at step S20 may also be selected as a transformation for which an acceptance criterion is maximum.

This acceptance criterion may be based in particular on the transfer rates $\rho_{P_i \to Q_j}(T)$ of information of the transformations of the codebook vis-à-vis the respective associations between base semantic meanings (bs) and corresponding inferred semantic meanings (is).

Depending on the use case, it may be for instance desirable to maximize a transfer rate for a first semantic meaning, but to minimize a transfer rate for a second, erroneous semantic meaning.

For instance, if a house catches fire, while it is obviously desirable to convey the meaning that a fire has just begun, it may be conversely preferable to minimize the misleading transfer of semantic meaning that someone might be fired, that is, might be dismissed from his job.

In this second approach, it is possible to use a stochastic policy π to select the transformation T to be used at step S20.

In this case, the policy π may be determined as a function of the observation m that has been drawn, and whose semantic meaning has to be transmitted to the recipient of the communication.

The policy π can be determined by many methods.

In a first variant, the policy π can be determined by reinforcement learning. In this case, solving the above equation (13) can be formulated as a Markov decision process, where a reinforced agent learns to find the policy π, which maps observations m to actions corresponding to selecting a transformation in the codebook that minimizes the risk of misinterpretation at the receiver.

In this purpose, different policy gradient algorithms may be used, such as actor-critic, Reinforce, Proximal policy optimization, etc.

The actor-critic method, the Reinforce method and the policy gradient algorithm are described in Ref.[3].

The proximal policy optimization method (a variant of the policy gradient algorithm) is further described by Ref.[4].

In this variant, the policy π is a parametric function (typically, a neural network) which defines a probability distribution based on the observation bm. In other words, the policy π(m) is a probability distribution on the codebook.

According to this variant, the policy π is a parametric function learnt by reinforcement learning based on experiments (interactions between TX and RX). An experiment in this case comprises a base observation bm, an action which is taken by selecting a certain transformation T of the codebook, and a reward. For instance, a reward can be '1' if the interpreter outputted a target observation tm endowed with the inferred meaning, and '0' if the outputted target observation tm was not endowed with the inferred meaning.).

The advantage of this method is that once policy π has been learnt (over the whole set of observations), the same policy can be applied every time a base observation bm has to be transmitted.

In a second variant, the policy π can be determined as follows.

In this case, the probability $\mu(P_i|m)$ has first to be calculated (or estimated); then, equation (13) has to be solved.

As an example, a possibility to solve equation (13) in this context comprises replacing the probability $\mu(P_i|m)$ with a probability distribution obtained at the output of the language interpreter of the transmission module TX (i.e., RX). Indeed, when a base observation bm is encoded by the base language generator as x = λ(bm), the own language interpreter of the reception module for that language, $I_\lambda$, is able to determine the base atom to which x belongs to and to recover the associated meaning.

In this variant, by contrast with the first variant, no parametric function has to be learnt. In this variant, being given a base observation bm, equation (11) is minimized (instead of equation (12), for which an average is sought over the whole set of observations). This minimization is carried out by replacing R(π) by R(π, m) in equation (13). Consequently, solving equation (13) yields an optimized policy $\pi_{Bayes}$ for each observation m which has to be transmitted. In this purpose, it is necessary to solve equation (11) to know the probability distribution μ(Pi|bm). In principle, given bm, the probability to obtain a base symbol belonging to base atom Pi is known (for instance as the class of the image in the example of Fig.1), and therefore the probability distribution μ(Pi|bm) is known.

However, in some embodiments the probability distribution μ(Pi|bm) is not known from the transmitter TX. In that case, instead of solving equation (11) based on the probability distribution μ(Pi|bm), equation (11) is solved based on an approximate value $\hat{\mu}(Pi|m)$ of μ(Pi|bm).

This approximate probability distribution $\hat{\mu}(Pi|m)$ may be calculated by using the interpreter $I_\lambda$ of the receiver RX which corresponds to the language generator based on the equation:

$$\hat{\mu}(Pi|m) = \mu(I_\lambda|tm)$$

Equation (11) is thus solved by replacing $\mu(Pi|bm)$ by $\mu(I_\lambda|tm)$ in equation (11).

One therefore minimizes:

$$R(\pi, bm) = 1 - \mathbb{E}_{T \sim q_m}\left[\sum_{\sigma ij} \hat{\mu}(P_i|m) \cdot \rho_{P_i \to Q_j}(T)\right] \quad (15)$$

Equation (15) (like equation (14)) can be solved by a linear programming method.

Results

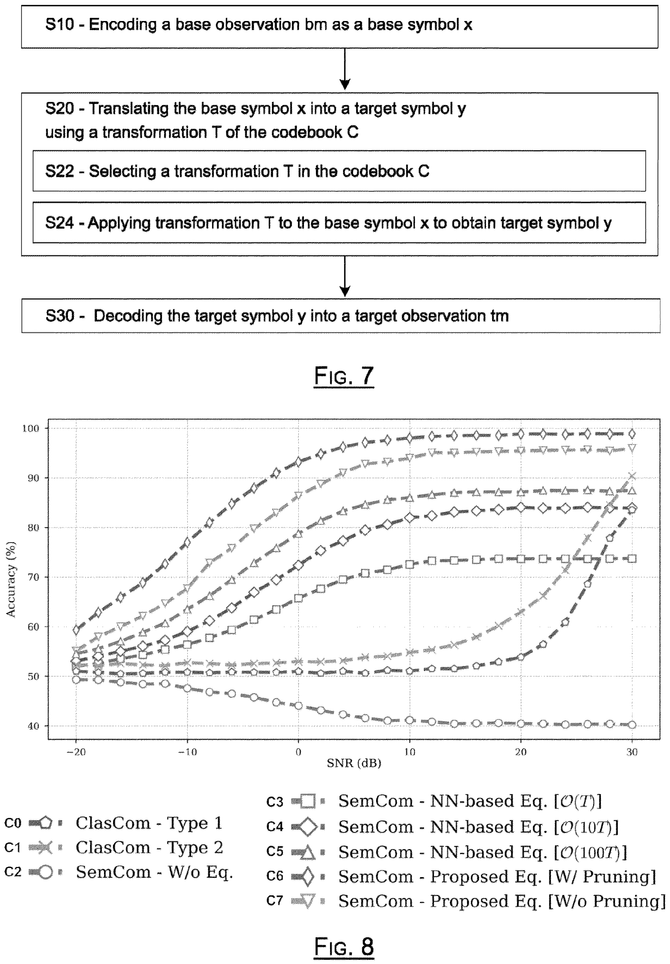

Fig.8 shows comparative results obtained by comparing eight different communication methods, relying on eight corresponding codebook construction methods.

The tests have been conducted based on the exemplary communication setting presented in relation with Fig.1: In each case, the language generator is configured to output a base symbol x to inform the receiver (after interpreting base symbol x) about which digit is present in a base observation bm, and the language interpreter is configured to generate an observation endowed with a meaning which is the parity of the digit present in the base observation bm.

The observations m are the colored MNIST dataset with images of digit of size 28x28. In this dataset, each image at random has a color selected between red, green, blue, and yellow. Here, colors can be understood as a semantic noise, as the focus in this example is put on recognizing either the digit in the image or its parity. In each case, the language generators λ, the language interpreters I, are considered given and obtained after and end-to-end training using e.g. an auto-encoder similar to approach in Ref.[2]. The set X of base symbols is set to $\mathcal{X} = \mathbb{R}^{2n}$ with n = 2. In other words, each base observation bm is encoded with two complex semantic symbols.

All the language generators are composed of a convolution layer with dimension 3*n*, followed by a rectifier linear unit and a max-pool operator, another convolutional layer with dimension 8*n*, followed by another max pooling operator, a dropout layer with probability 0.5, and a rectifier linear unit layer, whose output is flatened to feed a final linear layer of dimension 2*n*.

In contrast, each language interpreter only includes one linear layer of dimension 2*n*.

In addition, all convolutional layers use a kernel size equal to 5, and the max pool operators use a kernel size and a stride equal to 2. The power of the complex symbols x outputted by the language generators is normalized so that IE[x] = 1.

The first six methods below are used as benchmarks, to assess the respective performances of the following two methods which correspond to the present disclosure.

Methods 0 and 1 (benchmark): Classical communication without equalization - curves C0 and C1

In these methods, no semantic channel is used: Images are transmitted according to classical communication method, in which binary images are modulated using quadrature amplitude modulation (QAM) and transmitted through the (noisy) syntactic channel. For fair comparison, the QAM1024 (1024 bits per transmitted symbol) is adopted to represent images with approximately two complex QAM symbols. This comparison is provided to show the advantage of semantic based communication.

The difference between the two methods C0 and C1 is that they correspond to different strategies to interpret the received target symbols. At the receiver RX, the received target symbols are decoded, or interpreted, to retrieve binary images. In the first approach (curve C0), the receiver RX first interprets the digit in the received noisy images, then predicts its parity. In the second approach (curve C1), the receiver RX infers directly the parity of the digit from the noisy image, without any intermediary step.

Method 2 (benchmark): Without equalization - curve C2

In this method, the semantic channel is not equalized; that is, the only transformation T contained in the codebook is the identity function: The target symbol is identical to the base symbol x. This is of course the worst case scenario.

Methods 3 to 5(benchmark): Neural Network-based equalization - curves C3 to C5

For each of these methods, a codebook C is constructed which only contains a single transformation T. This transformation is modelled as a neural network (NN), which is trained in an end-to-end fashion using the language generator together with the language interpreter I. During the training of the NN-based transformation, the weights of the language generator and the language interpreter are frozen so that they are not impacted by the training procedure. The neural network is trained to maximize a classical cross-entropy loss between the actual output (the target observation tm) of the reception module and the desired output of the reception module

In Fig.8, curves C3 to C5 correspond to different complexities: Curve C3 represents the results obtained with a NN-based transformation having substantially the same complexity ($O(T)$) as the transformations in the codebook, thus, composed with only one linear layer of dimension $2n$; curves C4 and C5 represent the results obtained with NN-based transformations of respective complexities ten times and one hundred times the complexity ($O(T)$) of the transformations of the codebook (by including 10x, 100x more weights). In these latter cases, the learned transformation is composed of two feed forwards layers of dimensions $cn$ and $2n$ respectively.

Methods 6 and 7 according to the present disclosure: Linear transformations-based equalization - curves C6 and C7

The last two communication methods rely on codebooks constructed by executing codebook construction methods according to the present disclosure; these codebooks being constructed so as to contain, for each possible association, a linear transformation Tij configured to optimize the transfer rate of information from the base atom (corresponding to one of the different digits i=0 to 9) to the target atom (corresponding to a parity j, i.e. even or odd). Accordingly in these codebooks, each transformation Tij is expressed by an equation:

$$T_{ij}(x) = Ax + b \quad (16)$$

where A is a matrix and b is a vector.

More specifically, these codebooks were constructed by executing codebook construction methods in which the above-cited equation (6) was solved at step A20 to identify the different transformations Tij.

The difference between these two communication methods C6 and C7 is that in method 6, a pruning strategy as defined at step A34 is applied to reduce the size of the codebook, while conversely no pruning was performed in method 7.

Based in particular on the codebooks obtained in the methods 6 and 7, the eight different communication methods 0 to 7 have been compared.

In the methods, where applicable, an optimal transformation selection strategy was used to select the transformation to be used at step S20.

The main results of the tests are summarized in Fig.8 which shows comparative curves obtained for the eight compared communication methods.

Fig.8 shows in abscissa the signal/noise ratio, in decibels (dB), and in ordinate, the accuracy of the semantic transmission with the different compared methods (proportion of semantic meaning correctly transmitted).

As one can see, when no equalization is applied (curve C2), the overall performance of the communication is capped to 50%, which is what can be expected from a communication in which one has to guess randomly the parity of a digit without any hint.

All the methods according to the present disclosure (curves C6 and C7) outperform the benchmark curve C0.

In particular, the methods of curves C6-C7 clearly outperform the methods of the benchmark curve C2 (no equalization) and of curves C0-C1 and C3-C5. Fig.8 in particular clearly shows the gain in performance induced by semantic-based communications over classical communications methods C0-C1 against noise in the syntactic channel as shown in Ref [2]. The proposed methods of curves C6 and C7 in particular clearly outperform the NN-based equalization method of curve C3, which has the same complexity as the transformation in the codebook. Moreover, even when the complexity of the NN-based transformation increases, the accuracy of the communication at best reaches 90%, which is still significantly less than the performance of the methods of curves C6 and C7. This is because, the performance of the NN-based transformation is inherently limited by the capacity of the TX language generator and RX interpreter. However, the methods according to curves C6-C7 alleviate such limitation.

Although the present disclosure refers to specific exemplary embodiments, modifications may be provided to these examples without departing from the general scope of the invention as defined by the claims. In particular, individual characteristics of the different illustrated/mentioned embodiments may be combined in additional embodiments. Therefore, the description and the drawings should be considered in an illustrative rather than in a restrictive sense.

**Claims**

1. A computer-implemented method for constructing a codebook of transformation(s) to equalize a semantic channel between a language generator ($\lambda$) and a language interpreter (I),

   the language generator ($\lambda$) being configured to encode a base observation (bm) endowed with a base semantic meaning (bs) into a base symbol (x) endowed with the same base semantic meaning (bs);
   the language interpreter (I) being configured, based on a target symbol (y) endowed with a target semantic meaning (ts), to output a target observation (tm) endowed with the same target semantic meaning (ts);
   the codebook comprising at least one transformation (T) transforming base symbols (xi) endowed with base semantic meanings (bsi) into target symbols (yj) endowed with target semantic meanings (tsj);
   the method comprising the step of, an association (oij) being defined between a base semantic meaning (bsi) and an inferred target semantic meaning (tsi):

   A10) identifying, within a class of transformations, a transformation (T) for which a function of at least one transfer rate $\left(\rho_{P_i \rightarrow Q_j}(T)\right)$ for an association ($\sigma$ij) reaches at least a first predetermined threshold;

   a transfer rate $\left(\rho_{P_i \rightarrow Q_j}(T)\right)$ for an association of a transformation (T) representing, for the base symbols (x) endowed with the base semantic meaning (bsi), a probability for these base symbols to be transformed by the transformation (T) into target symbols (y), called inferred symbols, which are endowed with the inferred target semantic meaning (tsj) associated with the base semantic meaning (bsi).

2. A codebook construction method according to claim 1, wherein the class of transformations is a set of neural networks, of kernel mappings, or of affine transformations.

3. A codebook construction method according to claim 1 or 2, wherein the transformation (T) is identified at step A10 as a transformation (T) for which said function, when applied to tightened transfer rates $\left(\rho_{P_i \rightarrow Q_j}(T)\right)$ for said at least one association (oij), reaches at least a second predetermined threshold, a tightened transfer rate $\left(\rho_{P_i \rightarrow Q_j}(T)\right)$ for a transformation (T) representing a probability for the base symbols (xi) endowed with the base semantic meaning to be transformed by the transformation into target symbols (y) belonging to a strict subset of the set of the inferred symbols, for instance the set of target symbols located at a distance smaller than a threshold radius from a barycenter of a set (Qj) of the inferred symbols (yj).

4. A codebook construction method according to any one of claims 1 to 3, comprising pruning the codebook by removing one or more transformations from the codebook, when removing said one or more transformations does not reduce an accuracy (A(C)) of the codebook, the accuracy of the codebook being calculated by summating, over all associations (oij) between a base semantic meaning (bsi) and an inferred semantic meaning (isj), a maximum value of the transfer rate (pij) of information for the association.

5. A codebook construction method according to any one of claims 1 to 4, comprising, after having constructed an initial codebook (C), constructing an updated codebook (C') comprising only a subset of transformations of the initial codebook having lowest entropy values.

6. A codebook construction method according to any one of claims 1 to 5, wherein the method comprises pruning the codebook by selecting transformations to be kept in or to be removed from the codebook based on an acceptance criterion, the acceptance criterion for a transformation being based on the transfer rate (pij) of the transformation for at least one association between a base semantic meaning (bsi) and an inferred semantic meaning (isj).

7. A computer-implemented communication method for transmitting semantic information from a transmission module (TX) to a reception module (RX);
   the method comprising the steps of:

   S10) encoding a base observation (bm) as a base symbol (x) using a language generator ($\lambda$) of the transmission

module (TX);
S20) translating the base symbol (x) into a target symbol (y) using a transformation (T) of a codebook constructed with a method according to any one of claims 1 to 6;
S30) decoding the target symbol (y) to obtain a target observation (tm) using the language interpreter (I) of the reception module (RX).

8. The communication method of claim 7, wherein the transformation used at step S20 is selected based on the base observation (mi), the base symbol (xi), a predetermined probability distribution of the base observations, and/or a predetermined probability distribution of transformations that have been used in past steps S20.

9. The communication method of claim 7 or 8, wherein the transformation used at step S20 is selected as a or as the transformation maximizing a transfer rate (pij) from the base symbol (x) to a corresponding inferred target symbol (y).

10. The communication method according to any one of claims 7 to 9, wherein the transformation used at step S20 is selected as a transformation for which an acceptance criterion is maximum, the acceptance criterion being based on the transfer rate or rates $\left(\rho_{P_i \to Q_j}(T)\right)$ of information of at least one association.

11. The communication method according to any one of claims 7 to 10, wherein the transformation used at step S20 is selected based on a stochastic policy ($\pi$), said policy being determined by minimizing the expectation of a risk of misinterpretation when following a policy, given a base observation (bm), based on a probability distribution of the base observations,
the risk of misinterpretation when following a policy given a base observation (bm) being minimized by maximizing a weighted sum over all the associations of a transfer rate between the base semantic meaning (bsi) and the inferred semantic meaning (isj) of the association weighted by a probability of the base symbol (xi) given the base observation (mi).

12. A computer-implemented communication method according to any one of claims 7 to 11, wherein at step S20:

the base symbol (x) is translated into the target symbol (y), and then the target symbol is transmitted to a distant location;
the base symbol is transmitted to a distant location, and then the base symbol (x) is translated into the target symbol (y); or
the base symbol (x) undergoes a first transformation which yields a first output;
the first output is transmitted to a distant location, and then undergoes a second transformation,
the combination of the first and second transformations is the transformation of the codebook applied at step S20.

13. A computer program including instructions for executing the steps of a codebook construction method according to any one of claims 1 to 6, or of a communication method according to any one of claims 7 to 12, when said program is executed by a computer.

14. A non-transitory computer-readable storage medium readable by a computer and having recorded thereon a computer program according to claim 13.

Fig. 1

Fig. 2

CS   TX

bm → $\lambda$ → x → TU → y → IU → tm

CCU → T → TU

<u>FIG. 3</u>

$P_i$

$x_k$ ▲

$T^{-1}(Q_j) \cap P_i$

$T^{-1}(Q_j)$

$\mathcal{X}$

$T$

$y_l$ ■ $Q_j$

<u>FIG. 4</u>

$$\text{FIG. 5}$$

A10 - Identifying one or more transformations T

  A12 - Identifying the associations $\sigma_{ij}$

  A14 - Choosing a class of transformations

  A16 - Sampling base and target atoms $P_i$ and $Q_j$

  A18 - Determining transformation(s) T

A20 - Adding transformation(s) T to codebook C

A30 - Optimizing the codebook

  A32 - Identifying the information transfer matrix $\rho$

  A34 - Pruning the codebook

$$\text{FIG. 6}$$

S10 - Encoding a base observation bm as a base symbol x

S20 - Translating the base symbol x into a target symbol y
using a transformation T of the codebook C

S22 - Selecting a transformation T in the codebook C

S24 - Applying transformation T to the base symbol x to obtain target symbol y

S30 - Decoding the target symbol y into a target observation tm

## FIG. 7

C0 — ClasCom - Type 1
C1 — ClasCom - Type 2
C2 — SemCom - W/o Eq.

C3 — SemCom - NN-based Eq. $[\mathcal{O}(T)]$
C4 — SemCom - NN-based Eq. $[\mathcal{O}(10T)]$
C5 — SemCom - NN-based Eq. $[\mathcal{O}(100T)]$
C6 — SemCom - Proposed Eq. [W/ Pruning]
C7 — SemCom - Proposed Eq. [W/o Pruning]

## FIG. 8

Europäisches
Patentamt

European
Patent Office

Office européen
des brevets

**EUROPEAN SEARCH REPORT**

Application Number

EP 23 30 5579

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SANA MOHAMED ET AL: "Learning Semantics: An Opportunity for Effective 6G Communications", 2022 IEEE 19TH ANNUAL CONSUMER COMMUNICATIONS & NETWORKING CONFERENCE (CCNC), IEEE, 8 January 2022 (2022-01-08), pages 631-636, XP034083184, DOI: 10.1109/CCNC49033.2022.9700645 [retrieved on 2022-01-31] * Sections I-III * | 1-14 | INV.<br>H04L1/00 |
| A | BO YUFEI ET AL: "Learning Based Joint Coding-Modulation for Digital Semantic Communication Systems", 2022 14TH INTERNATIONAL CONFERENCE ON WIRELESS COMMUNICATIONS AND SIGNAL PROCESSING (WCSP), IEEE, 1 November 2022 (2022-11-01), pages 1-6, XP034295282, DOI: 10.1109/WCSP55476.2022.10039447 [retrieved on 2023-02-15] * Sections I-III * | 1-14 | |
| | | | TECHNICAL FIELDS SEARCHED (IPC) |
| A | LUO XUEWEN ET AL: "Semantic Communications: Overview, Open Issues, and Future Research Directions", IEEE WIRELESS COMMUNICATIONS, COORDINATED SCIENCE LABORATORY; DEPT. ELECTRICAL AND COMPUTER ENGINEERING; UNIVERSITY OF ILLINOIS AT URBANA-CHAMPAIGN, US, vol. 29, no. 1, 12 January 2022 (2022-01-12), pages 210-219, XP011905281, ISSN: 1536-1284, DOI: 10.1109/MWC.101.2100269 [retrieved on 2022-01-12] * the whole document * | 1-14 | H04L |

-/--

The present search report has been drawn up for all claims

| Place of search | Date of completion of the search | Examiner |
|---|---|---|
| Munich | 11 October 2023 | Kreppel, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 23 30 5579

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/092264 A1 (HAKKANI-TUR DILEK ZEYNEP [US] ET AL) 30 March 2017 (2017-03-30) | 1-6 | |
| A | * paragraphs [0066] - [0071]; figure 5 * <br> * paragraphs [0144] - [0150]; figure 15 * <br> ----- | 7-14 | |

TECHNICAL FIELDS
SEARCHED      (IPC)

The present search report has been drawn up for all claims

| Place of search | Date of completion of the search | Examiner |
|---|---|---|
| Munich | 11 October 2023 | Kreppel, Jan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

........................................................................................................

& : member of the same patent family, corresponding
    document

EPO FORM 1503 03.82 (P04C01)

**EP 4 447 349 A1**

## ANNEX TO THE EUROPEAN SEARCH REPORT
## ON EUROPEAN PATENT APPLICATION NO.

EP 23 30 5579

This annex lists the patent family members relating to the patent documents cited in the above-mentioned European search report.
The members are as contained in the European Patent Office EDP file on
The European Patent Office is in no way liable for these particulars which are merely given for the purpose of information.

11-10-2023

| Patent document cited in search report | Publication date | Patent family member(s) | Publication date |
|---|---|---|---|
| US 2017092264 A1 | 30-03-2017 | CN 108028043 A | 11-05-2018 |
| | | EP 3353776 A1 | 01-08-2018 |
| | | US 2017092264 A1 | 30-03-2017 |
| | | WO 2017053208 A1 | 30-03-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. PERROT ; N. COURTY ; R. FLAMARY ; A. HABRARD.** Mapping Estimation for Discrete Optimal Transport. *Advances in Neural Information Processing Systems,* 2016, vol. 29
- **M. SANA ; E. C. STRINATI.** Learning Semantics: An Opportunity for Effective 6G Communications. *2022 IEEE 19th Annual Consumer Communications & Networking Conference (CCNC),* January 2022, 631-636
- **SUTTON, RICHARD S. ; ANDREW G. BARTO.** Reinforcement learning: An introduction. MIT press, 2018
- **SCHULMAN, J. ; WOLSKI, F. ; DHARIWAL, P. ; RADFORD, A. ; KLIMOV, O.** Proximal policy optimization algorithms. *arXiv:1707.06347,* 2017